# FASCICULE DE BREVET EUROPEEN

(11) **EP 3 233 480 B1**
(45) Date de publication et mention de la délivrance du brevet: **20.02.2019**
(21) Numéro de dépôt: 15821123.5
(22) Date de dépôt: 15.12.2015
(51) Int. Cl.: B32B 17/10, C03C 17/00, C03C 17/36, H05B 3/84

(54) **SUBSTRAT EN VERRE MUNI DE BANDES CONDUCTRICES A BASE DE CUIVRE**
GLASSUBSTRAT MIT KUPFERHALTIGEN LEITFÄHIGEN STREIFEN
GLASS SUBSTRATE PROVIDED WITH CONDUCTIVE STRIPS CONTAINING COPPER

(30) Priorité: 18.12.2014 FR 1462758
(43) Date de publication de la demande: 25.10.2017
(73) Titulaire: Saint-Gobain Glass France, 92400 Courbevoie (FR)
(72) Inventeur: RANO, Simon, 95800 Courdimanche (FR); BRIQUET, Clément, 60157 Elincourt Sainte Marguerite (FR); BEYRLE, André, 60170 Tracy Le Val (FR)
(74) Mandataire: Saint-Gobain Recherche
(86) Numéro de dépôt international: PCT/FR2015/053508
(87) Numéro de publication internationale: WO 2016/097579

(56) Documents cités:
- WO-A1-2005/068385
- FR-A- 1 544 718

## Description

La présente invention se rapporte au domaine des substrats en verre sur lesquels on dépose par sérigraphie des bandes conductrices à base de cuivre. Ces substrats trouvent notamment des applications dans le domaine de l'automobile et plus particulièrement pour les vitrages chauffants.

Dans les procédés actuels de sérigraphie sur verre, les fils conducteurs sont faits à partir d'un émail à base d'argent. Cet émail contient au moins une résine, de la fritte de verre, des cristaux, poudres et / ou flocons d'argent de dimension micrométrique et au moins un solvant. Il se présente sous forme d'une pâte ayant une certaine viscosité, ce qui lui permet d'être généralement sérigraphié sur le substrat à l'aide d'un écran. Une fois déposé, l'émail est ensuite séché à 150°C environ puis cuit sous air à une température comprise entre 550°C et 700°C pendant une durée variant de 2 à 10 minutes. L'émail ainsi cuit se présente sous forme solide. Des cosses de contacts peuvent être soudées pour permettre l'alimentation électrique des fils conducteurs. Ce procédé est le plus souvent intégré au procédé de mise en forme du verre. Les fils conducteurs à base d'argent ainsi formés ont classiquement une épaisseur comprise entre 3 et 30 µm.

Dans les vitrages à réseau chauffant, une série de bandes étroites (également appelées « pistes ») de résistance sont sérigraphiées sur la surface d'une feuille de verre, avant les opérations de bombage et/ou trempe, de sorte que la cuisson de la composition électroconductrice s'effectue lors de ces opérations de mise en forme. La composition électroconductrice est faite d'une suspension pâteuse d'argent métallique et d'une fritte (c'est-à-dire d'un verre à bas point de fusion) dans un liant organique. Ces bandes de résistance débouchent sur des bandes collectrices plus larges, situées près des bords du vitrage. Ces bandes collectrices, encore appelées barres omnibus, ou « busbar » selon la terminologie anglosaxone couramment utilisée, sont généralement faites d'une composition identique à celles des bandes de résistance et sont déposées simultanément et de la même façon. Les amenées de courant sont ensuite soudées sur ces bandes collectrices. Les constructeurs imposent à ces collecteurs de ne pas dépasser une certaine température, ce qui impose d'avoir des largeurs assez grandes ainsi que des épaisseurs suffisantes et par conséquent de nécessiter des quantités relativement importantes d'argent. Or l'argent est un métal assez rare et spéculatif. Aujourd'hui, son prix au kilo se situe aux alentours de 450€ mais il est arrivé qu'il monte jusqu'à 850 € par exemple en 2012. Or le prix de la pâte conductrice est directement lié au prix de l'argent puisque ce composant est le constituant essentiel. Une pâte d'émail à base d'argent comprend en effet entre 60 et 88%en poids d'argent. On cherche donc à limiter la quantité d'argent et l'objectif de la présente invention est de substituer totalement ou partiellement l'argent par un autre métal moins coûteux mais qui possède de bonnes propriétés conductrices. L'argent possède également la propriété de résister aux traitements à haute température. Lors de la mise en forme d'un vitrage, la pâte est cuite à une température de 550°C à 630°C pour un verre feuilleté et à une température de 610°C à 700°C pour un verre trempé. D'autre part, les fils conducteurs doivent pouvoir assurer un chauffage pendant au moins une dizaine d'années, durée de vie minimale d'un véhicule, tout en étant soumis à la corrosion ainsi qu'à des écarts de température importants pouvant aller typiquement de -40°C à 105°C. Il est par conséquent nécessaire de substituer l'argent par un métal qui résiste à ces mêmes conditions.

Le cuivre est un métal bon marché (coût de moins de 10€ le kilo) qui possède d'excellentes qualités de conduction, comparables à l'argent, mais qui ne sont aucunement garanties dans le temps lorsqu'il est exposé à l'air ambiant. D'autre part, le cuivre est un métal aux propriétés de résistance à la corrosion quasi-nulles lorsque la température dépasse 300°C, ou lorsqu'il est placé dans un environnement acide ou basique. Si des pâtes de cuivre sont utilisées de façon très courante dans le secteur de l'électronique, par exemple pour des circuits imprimés ou des condensateurs céramiques, elles sont systématiquement cuites sous atmosphère inerte, voire même réductrice, pendant des durées d'environ 20 minutes. Dans le domaine de l'automobile ou du bâtiment, lorsque les panneaux de verre utilisés sont de grande dimension et nécessitent un formage particulier, il n'est pas envisageable d'utiliser des fours à atmosphère contrôlée, notamment pour des raisons de coût.

La présente invention propose un vitrage comportant des fils conducteurs ou collecteurs électriques à base de cuivre, résistant à des températures élevées et à la corrosion, ainsi que le procédé de fabrication d'un tel vitrage.

Le vitrage selon l'invention comprend au moins une feuille de verre munie sur une des faces d'un réseau électrique constitué de bandes de résistance et de bandes collectrices, dans lequel au moins une partie d'une face comprend au moins une bande obtenue à partir d'une composition électroconductrice comprenant une pâte d'argent, ladite bande étant en contact avec une autre bande obtenue à partir d'une composition électroconductrice comprenant une pâte de cuivre, ladite autre bande obtenue à partir d'une composition électroconductrice comprenant une pâte de cuivre étant totalement recouverte d'une couche protectrice d'émail.

Les bandes comprenant la composition électroconductrice à base de pâte de cuivre sont recouvertes d'une couche d'émail, assurant la protection contre l'oxydation et la corrosion. L'émail est une pâte comprenant une fritte de verre, éventuellement des pigments inorganiques et un médium souvent à base de résine et de solvant permettant la mise en suspension des particules inorganiques présentes et la processabilité à l'état liquide. Le pigment inorganique utilisé fréquemment dans le domaine de l'automobile est un pigment noir à base de spinelles de chrome-cuivre, cuivre, de spinelles de cuivre-manganèse voir de spinelles de fer-manganèse. Le médium se consume lors de la cuisson de l'émail et la fritte de verre va permettre d'assurer la fixation au substrat et une bonne tenue mécanique de l'émail. L'émail utilisé pour recouvrir la composition électroconductrice à base de pâte de cuivre est un émail riche en fritte de verre, et éventuellement incolore : il contient plus de 50% en poids de fritte de verre, et de 0 à 30% de pigment. Avantageusement, la teneur en pigment dans cet émail protecteur est inférieure ou égale à 15%en poids. La bande qui est obtenue à partir de la composition électroconductrice à base de cuivre doit bénéficier d'une protection totale par la couche d'émail. Les parties supérieures et latérales de cette bande doivent être protégées.

Le contact entre les deux bandes conductrices, l'une obtenue à partir d'une composition à base de pâte de cuivre et l'autre à partir d'une composition à base d'une pâte d'argent, se fait au niveau des extrémités de la bande à base de pâte de cuivre. En effet, si la bande de cuivre est totalement recouverte par une couche d'émail, elle devient inaccessible électriquement. Il est nécessaire qu'au moins un contact se fasse entre la bande de cuivre et la bande d'argent avant que la bande de cuivre ne soit totalement encapsulée dans la couche d'émail.

De façon avantageuse, la couche d'émail protectrice recouvre la totalité de la bande en cuivre et une partie de la bande en argent.

Selon un mode de réalisation du vitrage selon l'invention, pour assurer un bon contact entre les deux bandes en matériau différent, la bande obtenue à partir de la composition électroconductrice comprenant la pâte d'argent est partiellement recouverte par la bande obtenue à partir de la composition électroconductrice comprenant la pâte de cuivre. La couche protectrice d'émail qui recouvre la bande en cuivre recouvre donc également partiellement la bande en argent. La zone de contact entre le cuivre et l'argent est ainsi recouverte par la couche d'émail protectrice. Ce mode de réalisation permet de protéger le cuivre sur l'ensemble de sa surface et de masquer l'interface entre les deux bandes, qui peut être sujette à des défauts visuels dus à l'intermigration de l'argent et du cuivre.

Selon un autre mode de réalisation, la bande en argent peut recouvrir partiellement la bande en cuivre.

Selon un mode de réalisation du vitrage selon l'invention, la bande en argent et/ou la bande en cuivre peuvent être positionnées sur une couche d'émail déposée sur la feuille de verre. Ainsi les bandes sont complètement masquées et ne sont plus visibles. La présence de cette couche d'émail déposée sur la feuille de verre permet avantageusement une meilleure adhésion des bandes obtenues à partir des pâtes électroconductrices. La composition de cette couche d'émail déposée directement sur la feuille de verre peut être identique ou différente de la composition de la couche d'émail protectrice.

La composition électroconductrice comprenant la pâte de cuivre comprend entre 70 et 90%en poids de poudre de cuivre. La teneur en fritte de verre de cette composition est avantageusement inférieure à 15%en poids. Si la bande en cuivre n'est pas en contact direct avec la feuille de verre mais est déposée sur une couche d'émail telle que décrite précédemment, il est envisageable que la composition électroconductrice comprenant la pâte de cuivre soit exempte de fritte de verre.

La composition électroconductrice comprenant la pâte de cuivre comprend également entre 10 et 20% de médium, qui se consumera également lors des traitements thermiques.

La composition électroconductrice comprenant la pâte d'argent comprend entre 70 et 90%en poids de poudre d'argent. La teneur en fritte de verre de cette composition est avantageusement inférieure à 15%en poids.

Les épaisseurs des différentes couches sont mesurées sur le produit fini, après séchage et cuisson de l'émail ou des pâtes utilisées. L'épaisseur de la bande en cuivre est comprise entre 5 et 50 µm et préférentiellement entre 5 et 30 µm.

La couche protectrice d'émail recouvrant la bande comprenant la pâte de cuivre a une épaisseur, mesurée après cuisson, comprise entre 5 et 40 µm et préférentiellement entre 10 et 30 µm.

Une partie d'au moins une des faces du vitrage selon l'invention comprend des bandes collectrices et/ ou des bandes de résistance obtenues à partir de la composition électroconductrice à base de pâte de cuivre et recouvertes de la couche d'émail protectrice.

De façon préférée, les bandes de résistance en cuivre sont directement déposées sur la feuille de verre et sont recouvertes d'une couche d'émail protectrice dénuée de pigment.

Le vitrage selon la présente invention peut être un verre trempé ou un verre feuilleté. Dans le cas d'un verre trempé, la face de la feuille de verre comprenant le réseau électrique sera la face interne de la feuille de verre. Dans le cas d'un verre feuilleté comprenant au moins deux feuilles de verre, les faces comprenant le réseau électrique sont préférentiellement les faces 2, 3, ou 4 si on considère que la face 1 est la face extérieure du véhicule.

La présente invention porte également sur un procédé de fabrication d'un vitrage tel que décrit précédemment. Le procédé comprend les étapes suivantes :
- dépôt d'une couche de pâte d'argent sur au moins une partie d'au moins une des faces de la feuille de verre pour constituer une bande,
- dépôt d'une couche de pâte de cuivre pour constituer une autre bande,
   les étapes de dépôt étant réalisés de sorte qu'il existe au moins une zone de contact entre les deux couches puis
- dépôt d'une couche protectrice d'émail sur la totalité de la couche de pâte de cuivre, et
- cuisson de l'ensemble des couches déposées à une température comprise entre 550 et 700°C, sous air, pendant une durée de 2 à 10 minutes.

Les étapes de dépôt des couches de pâte d'argent et de couche de pâte de cuivre peuvent être réalisées dans un ordre quelconque. De façon préférée, les étapes de dépôt des différentes couches sont réalisées par sérigraphie. La sérigraphie est une technique de dépôt bien connue qui utilise un écran de sérigraphie, constitué d'un tissu sur lequel le motif à imprimer est reproduit et un râcle permettant d'appliquer une force de cisaillement suffisante pour faire passer la composition pâteuse au travers des mailles de l'écran par les ouvertures correspondant au motif à imprimer et ainsi la déposer sur le support. L'écran de sérigraphie doit présenter une ouverture de maille compatible avec la taille des particules contenues dans les compositions de pâtes. Les fils constituant l'écran peuvent être des fils en acier ou en matière polymérique, par exemple en polyester. Le nombre de fils par centimètre varie en général de 34 à 200 et leur diamètre varie entre 27 et 100 µm.

Sous réserve de limites granulométriques et rhéologiques de la pâte à déposer, il est également possible d'envisager les étapes de dépôt des différentes couches par un procédé d'impression digitale. On citera par exemple la technique de jet d'émail qui permet de réaliser des dépôts de précision et d'obtenir une résolution proche de celle d'une impression par sérigraphie.

Il est également possible de déposer les couches et notamment la couche à base de pâte de cuivre et/ou la couche d'émail protectrice par une technique de pulvérisation. La bande en cuivre est totalement encapsulée dans une couche d'émail protectrice. Un des avantages de l'invention est notamment de pouvoir réaliser le dépôt des couches en cuivre avec des techniques moins précises que la sérigraphie ou l'impression digitale.
Les étapes de dépôt des couches de pâtes de cuivre et/ou d'argent peuvent être réalisées de façon à former des motifs imprimés sur la partie de la feuille de verre sur laquelle elles sont effectuées.

L'étape de cuisson des couches déposées est réalisée sous air. Le procédé selon la présente invention permet d'éviter la nécessité d'effectuer le traitement thermique sous atmosphère contrôlée, ce qui nécessiterait l'utilisation de fours spécifiques. Le cuivre, protégé par la couche d'émail ne subit pas ou extrêmement peu d'oxydation lors de l'étape de cuisson.

Le procédé selon l'invention peut comprendre une étape de dépôt d'une couche d'émail sur la face de la feuille préalablement au dépôt des couches de cuivre et/ou d'argent. Cette couche d'émail comprend alors une ou plusieurs fritte(s) de verre pour permettre l'adhésion à la feuille de verre et un pigment opacifiant pour masquer l'empilement conducteur.

Le procédé selon l'invention permet d'obtenir des couches de cuivre possédant des résistances comparables à celles de l'argent. Lors des tests de vieillissement, les bandes de cuivre protégées par la couche d'émail ne sont pas endommagées.

Le vitrage selon la présente invention peut avoir des applications dans l'ensemble des domaines où l'argent est appliqué sur du verre pour ses propriétés de conduction électrique. Une partie de l'argent peut être remplacée par du cuivre. On citera par exemple les réseaux de dégivrage de vitrages de véhicules : les bus-bars peuvent avantageusement être en cuivre, à condition de recouvrir les bandes de cuivre d'une couche d'émail protectrice. Il est également envisageable de remplacer les busbars d'alimentation des pare-brise chauffants, les capteurs de pluie ou les antennes par un dépôt en cuivre.

Le vitrage selon l'invention peut trouver des applications dans différents domaines. On peut citer par exemple, les radiateurs chauffants, les plaques à induction, les chauffe-plats ou les collecteurs photovoltaïques.

Ainsi, le vitrage selon l'invention est tel qu'une partie de sa face comprend des bandes collectrices ou des bandes de résistance obtenues à partir de la composition électroconductrice à base de pâte de cuivre et recouvertes de la couche d'émail protectrice. De façon préférée, les bandes de résistance en cuivre sont directement déposées sur la feuille de verre et sont recouvertes d'une couche d'émail protectrice dénuée de pigment. En effet, ces bandes de résistance sont généralement plus fines que les bandes conductrices et il peut être esthétiquement avantageux de les recouvrir d'une couche d'émail incolore.

La présente invention porte également sur des Pare-brise chauffants, capteurs de pluie, antennes, les radiateurs chauffants, plaques à induction, chauffe-plats ou collecteurs photovoltaïques comprenant un vitrage tel que décrit précédemment.

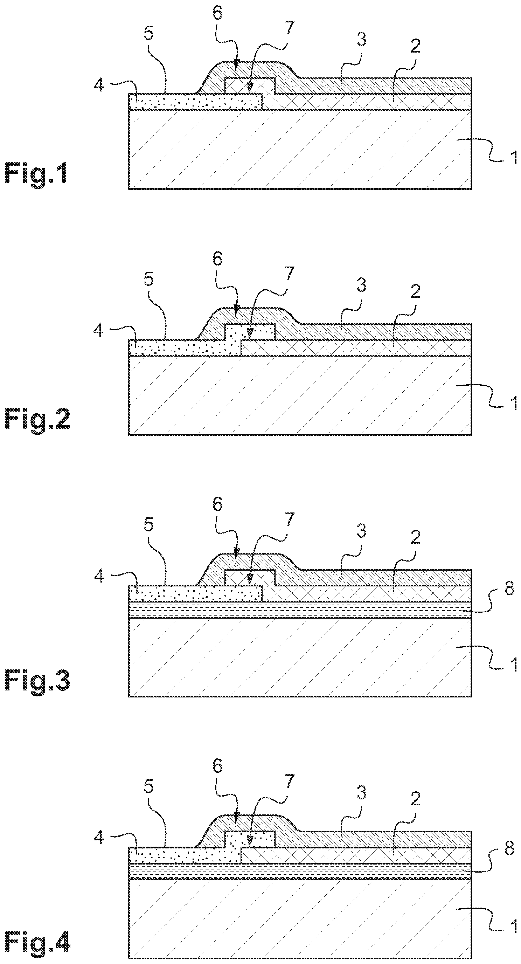

Les figures 1 à 4 illustrent l'invention et représentent des coupes transversales de vitrages selon la présente invention.

Sur la figure 1, la feuille de verre (1) est recouverte d'une bande d'argent (4) et d'une bande de cuivre (2). Ces deux bandes sont directement déposées sur la feuille de verre. La bande d'argent est déposée dans un premier temps, et dans un second temps, la bande de cuivre est déposée de façon à recouvrir partiellement la bande d'argent. La totalité de la bande de cuivre (2) est recouverte d'une couche de protection en émail (3). Cette couche (3) déborde également sur une partie de la bande d'argent (4) de façon à créer une zone de recouvrement (6) en émail de la zone de contact (7) entre la bande d'argent et la bande de cuivre. Cette configuration permet de laisser une partie de la bande d'argent non recouverte par la couche d'émail (3). Il s'agit de la zone (5) qui constitue la zone de soudure des cosses de contacts. De façon usuelle, ces cosses sont soudées sur une unique couche d'argent. Malgré l'empilement de deux couches sérigraphiées (bande de cuivre et émail protecteur), la zone de soudure reste similaire à celle que l'on trouve dans des réseaux électriques habituels c'est à dire ne comprenant que des bandes obtenues à partir d'une composition électroconductrice à base de pâte d'argent.

Sur la figure 2, la feuille de verre (1) est également recouverte d'une bande d'argent (4) et d'une bande de cuivre (2) et la bande de cuivre (2) est celle qui est déposée la première. La bande d'argent (4) est ensuite déposée et recouvre partiellement la bande de cuivre. La partie de la bande de cuivre non recouverte par la bande d'argent est ensuite protégée par la couche d'émail protectrice.

La figure 3 représente la coupe transversale d'un vitrage sur la face duquel une couche d'émail (8) est déposée. Les bandes de cuivre (2) et d'argent (4) sont déposées avec la même configuration que celle décrite à la figure 1, directement sur une couche d'émail (8). La couche d'émail protectrice (3) est déposée sur la bande de cuivre, qui est ainsi totalement encapsulée et non visible dans le vitrage. La zone de soudure (5) reste facilement accessible et n'est constituée que de la bande d'argent (4).

La figure 4 représente la coupe transversale d'un vitrage sur la face duquel on dépose une couche d'émail (8), les bandes de cuivre et d'argent étant déposés selon la même configuration que celle décrite à la figure 2.

La couche d'émail (8) est une couche qui comprend nécessairement au moins une fritte de verre pour permettre une bonne adhésion au verre.

## Revendications

1. Vitrage comprenant au moins une feuille de verre munie sur une des faces d'un réseau électrique constitué de bandes de résistance et de bandes collectrices, **caractérisé en ce qu'**au moins une partie d'une face comprend au moins une bande obtenue à partir d'une composition électroconductrice comprenant une pâte d'argent, ladite bande étant en contact avec une autre bande obtenue à partir d'une composition électroconductrice comprenant une pâte de cuivre, ladite autre bande obtenue à partir d'une composition électroconductrice comprenant une pâte de cuivre étant totalement recouverte d'une couche protectrice d'émail.

2. Vitrage selon la revendication précédente **caractérisé en ce que** le contact entre les bandes en cuivre et en argent se fait au niveau des extrémités de la bande obtenue à partir de la composition électroconductrice comprenant la pâte de cuivre.

3. Vitrage selon l'une des revendications précédentes **caractérisé en ce que** la bande en cuivre recouvre partiellement la bande en argent.

4. Vitrage selon l'une des revendications 1 ou 2 **caractérisé en ce que** la bande en argent recouvre partiellement la bande en cuivre.

5. Vitrage selon l'une des revendications précédentes **caractérisé en ce que** la bande en cuivre et/ou la bande en argent est positionnée sur une couche d'émail déposée sur la feuille de verre.

6. Vitrage selon la revendication précédente **caractérisé en ce que** la composition électroconductrice à base de cuivre comprend entre 70 et 90 %en poids de poudre de cuivre et moins de 15%en poids de fritte de verre.

7. Vitrage selon l'une des revendications précédentes **caractérisé en ce que** l'épaisseur, mesurée après cuisson, de la bande comprenant la pâte de cuivre est comprise entre 5 et 50 µm, de préférence entre 5 et 30µm.

8. Vitrage selon l'une des revendications précédentes **caractérisé en ce que** la couche d'émail protectrice recouvrant la bande en cuivre a une épaisseur mesurée après cuisson comprise entre 5 et 40 µm, de préférence entre 10 et 30 µm.

9. Vitrage selon l'une des revendications précédentes **caractérisé en ce que** une partie d'au moins une face comprend des bandes collectrices et/ou des bandes de résistance obtenues à partir de la composition électroconductrice à base de pâte de cuivre et recouvertes de la couche d'émail protectrice.

10. Vitrage selon la revendication 9 **caractérisé en ce que** les bandes de résistance en cuivre sont directement déposées sur la feuille de verre et sont recouvertes d'une couche d'émail protectrice dénuée de pigment.

11. Procédé de fabrication d'un vitrage selon l'une des revendications précédentes **caractérisé en ce qu'**il comprend les étapes suivantes :
- dépôt d'une couche de pâte d'argent sur au moins une des faces de la feuille de verre pour constituer une bande,
- dépôt d'une couche de pâte de cuivre pour constituer une autre bande,
les étapes de dépôt étant réalisés de sorte qu'il existe au moins une zone de contact entre les deux couches puis
- dépôt d'une couche protectrice d'émail sur la totalité de la couche de pâte de cuivre, et
- cuisson de l'ensemble des couches déposées à une température comprise entre 550 et 700°C, sous air, pendant une durée de 2 à 10 minutes.

12. Procédé selon la revendication 11 **caractérisé en ce qu'**au moins une des étapes de dépôt est effectuée par sérigraphie.

13. Procédé selon la revendication 11 **caractérisé en ce qu'**au moins une des étapes de dépôt est effectuée par impression digitale.

14. Procédé selon l'une des revendications 11 à 13 **caractérisé en ce qu'**il comprend une étape préalable de dépôt d'une couche d'émail sur la face de la feuille de verre sur laquelle les étapes de dépôt des couches de pâte de cuivre et/ ou d'argent seront réalisées.

15. Pare-brise chauffants, capteurs de pluie, antennes, les radiateurs chauffants, plaques à induction, chauffe-plats ou collecteurs photovoltaïques comprenant un vitrage selon l'une des revendications 1 à 10.

## Patentansprüche

1. Verglasung, die mindestens eine Glasscheibe umfasst, die auf einer der Seiten mit einem Stromnetz versehen ist, das aus Widerstandsstreifen und Kollektorstreifen besteht, **dadurch gekennzeichnet, dass** mindestens ein Teil einer Seite mindestens einen Streifen umfasst, der ausgehend von einer stromleitenden Zusammensetzung erhalten wird, die eine Silberpaste umfasst, wobei der Streifen mit einem anderen Streifen in Berührung ist, der ausgehend von einer stromleitenden Zusammensetzung erhalten wird, die eine Kupferpaste umfasst, wobei der andere Streifen, der ausgehend von einer stromleitenden Zusammensetzung erhalten wird, die eine Kupferpaste umfasst, vollständig mit einer Emailschutzschicht bedeckt ist.

2. Verglasung nach dem vorhergehenden Anspruch, **dadurch gekennzeichnet, dass** die Berührung zwischen dem Kupferstreifen und dem Silberstreifen im Bereich der Enden des Streifens erfolgt, der ausgehend von der stromleitenden Zusammensetzung, die die Kupferpaste umfasst, erhalten wird.

3. Verglasung nach einem der vorhergehenden Ansprüche, **dadurch gekennzeichnet, dass** der Kupferstreifen teilweise den Silberstreifen bedeckt.

4. Verglasung nach einem der Ansprüche 1 oder 2, **dadurch gekennzeichnet, dass** der Silberstreifen teilweise den Kupferstreifen bedeckt.

5. Verglasung nach einem der vorhergehenden Ansprüche, **dadurch gekennzeichnet, dass** der Kupferstreifen und/oder der Silberstreifen auf einer Emailschicht, die auf der Glasscheibe abgeschieden ist, positioniert ist.

6. Verglasung nach dem vorhergehenden Anspruch, **dadurch gekennzeichnet, dass** die kupferhaltige stromleitende Zusammensetzung zwischen 70 und 90 Gew.-% Kupferpulver und weniger als 15 Gew.-% Glasfritte umfasst.

7. Verglasung nach einem der vorhergehenden Ansprüche, **dadurch gekennzeichnet, dass** die Stärke des Streifens, der die Kupferpaste umfasst, die nach dem Brennen gemessen wird, zwischen 5 und 50 µm, bevorzugt zwischen 5 und 30 µm beträgt.

8. Verglasung nach einem der vorhergehenden Ansprüche, **dadurch gekennzeichnet, dass** die Emailschutzschicht, die den Kupferstreifen bedeckt, eine Stärke, die nach dem Brennen gemessen wird, umfasst, die zwischen 5 und 40 µm, bevorzugt zwischen 10 und 30 µm beträgt.

9. Verglasung nach einem der vorhergehenden Ansprüche, **dadurch gekennzeichnet, dass** ein Teil mindestens einer Seite Kollektorstreifen und/oder Widerstandsstreifen umfasst, die ausgehend von der kupferpastehaltigen stromleitenden Zusammensetzung erhalten werden und mit der Emailschutzschicht bedeckt sind.

10. Verglasung nach Anspruch 9, **dadurch gekennzeichnet, dass** die Widerstandsstreifen aus Kupfer direkt auf der Glasscheibe abgeschieden sind und mit einer Emailschutzschicht bedeckt sind, die kein Pigment aufweist.

11. Verfahren zur Herstellung einer Verglasung nach einem der vorhergehenden Ansprüche, **dadurch gekennzeichnet, dass** es die folgenden Schritte umfasst:
- Abscheiden einer Schicht aus Silberpaste auf mindestens einer der Seiten der Glasscheibe, um einen Streifen zu bilden,
- Abscheiden einer Schicht aus Kupferpaste, um einen anderen Streifen zu bilden,
wobei die Abscheidungsschritte derart ausgeführt werden, dass mindestens eine Berührungszone zwischen den zwei Schichten besteht, dann
- Abscheiden einer Emailschutzschicht auf der gesamten Schicht aus Kupferpaste, und
- Brennen der Einheit der abgeschiedenen Schichten bei einer Temperatur zwischen 550 und 700 °C unter Luft während einer Dauer von 2 bis 10 Minuten.

12. Verfahren nach Anspruch 11, **dadurch gekennzeichnet, dass** mindestens einer der Abscheidungsschritte durch Serigrafie ausgeführt wird.

13. Verfahren nach Anspruch 11, **dadurch gekennzeichnet, dass** mindestens einer der Abscheidungsschritte durch digitales Drucken ausgeführt wird.

14. Verfahren nach einem der Ansprüche 11 bis 13, **dadurch gekennzeichnet, dass** es einen vorausgehenden Schritt des Abscheidens einer Emailschicht auf der Seite der Glasscheibe umfasst, auf der die Abscheidungsschritte der Schichten aus Kupferpaste und/oder Silberpaste ausgeführt werden.

15. Heizende Windschutzscheibe, Regensensoren, Antennen, Heizradiatoren, Induktionsplatten, Warmhalteplatten oder fotovoltaische Kollektoren, die eine Verglasung nach einem der Ansprüche 1 bis 10 umfassen.

## Claims

1. A glazing comprising at least one glass sheet provided on one of the faces with an electrical network consisting of resistance strips and collector strips, **characterized in that** at least one portion of one face comprises at least one strip obtained from an electrically conductive composition comprising a silver paste, said strip being in contact with another strip obtained from an electrically conductive composition comprising a copper paste, said other strip obtained from an electrically conductive composition comprising a copper paste being completely covered with a protective enamel layer.

2. The glazing as claimed in the preceding claim, **characterized in that** the contact between the copper and silver strips is made at the ends of the strip obtained from the electrically conductive composition comprising the copper paste.

3. The glazing as claimed in either of the preceding claims, **characterized in that** the copper strip partially covers the silver strip.

4. The glazing as claimed in either of claims 1 and 2, **characterized in that** the silver strip partially covers the copper strip.

5. The glazing as claimed in one of the preceding claims, **characterized in that** the copper strip and/or the silver strip is positioned on an enamel layer deposited on the glass sheet.

6. The glazing as claimed in the preceding claim, **characterized in that** the copper-based electrically conductive composition comprises between 70% and 90% by weight of copper powder and less than 15% by weight of glass frit.

7. The glazing as claimed in one of the preceding claims, **characterized in that** the thickness, measured after firing, of the strip comprising the copper paste is between 5 and 50 µm, preferably between 5 and 30 µm.

8. The glazing as claimed in one of the preceding claims, **characterized in that** the protective enamel layer covering the copper strip has a thickness, measured after firing, of between 5 and 40 µm, preferably between 10 and 30 µm.

9. The glazing as claimed in one of the preceding claims, **characterized in that** a portion of at least one face comprises collector strips and/or resistance strips that are obtained from the electrically conductive composition based on copper paste and that are covered with the protective enamel layer.

10. The glazing as claimed in claim 9, **characterized in that** the copper resistance strips are directly deposited on the glass sheet and are covered with a pigment-free protective enamel layer.

11. A process for manufacturing a glazing as claimed in one of the preceding claims, **characterized in that** it comprises the following steps:
- depositing a layer of silver paste on at least one of the faces of the glass sheet in order to form a strip,
- depositing a layer of copper paste in order to form another strip, the deposition steps being carried out so that there is at least one contact zone between the two layers, then
- depositing a protective enamel layer over the whole of the layer of copper paste, and
- firing all of the layers deposited at a temperature of between 550°C and 700°C, in air, for a duration of from 2 to 10 minutes.

12. The process as claimed in claim 11, **characterized in that** at least one of the deposition steps is carried out by screen printing.

13. The process as claimed in claim 11, **characterized in that** at least one of the deposition steps is carried out by digital printing.

14. The process as claimed in one of claims 11 to 13, **characterized in that** it comprises a prior step of depositing an enamel layer on the face of the glass sheet on which the steps of depositing the layers of copper and/or silver paste will be carried out.

15. Heated windshields, rain sensors, antennae, radiant heaters, induction hobs, food warmers or photovoltaic collectors comprising a glazing as claimed in one of claims 1 to 10.
